# EUROPÄISCHE PATENTSCHRIFT

(11) **EP 1 115 545 B1**
(45) Veröffentlichungstag und Bekanntmachung des Hinweises auf die Patenterteilung: **17.07.2002**
(21) Anmeldenummer: 00920712.7
(22) Anmeldetag: 15.04.2000
(51) Int. Cl.: B29C 43/58, G03F 9/00

(54) **EINRICHTUNG UND VERFAHREN ZUR ÜBERTRAGUNG VON MIKROSTRUKTUREN**
DEVICE AND METHOD FOR TRANSFERRING MICROSTRUCTURES
DISPOSITIF ET PROCEDE POUR LE TRANSFERT DE MICROSTRUCTURES

(30) Priorität: 27.05.1999 DE 19925175
(43) Veröffentlichungstag der Anmeldung: 18.07.2001
(73) Patentinhaber: JENOPTIK Aktiengesellschaft, 07743 Jena (DE)
(72) Erfinder: REUTHER, Frank, D-07407 Rudolstadt (DE); SPRINGER, Alf, D-07751 Milda (DE); MÜLLER, Lutz, D-07747 Jena (DE)
(74) Vertreter: Bertram, Helmut
(86) Internationale Anmeldenummer: EP0003438
(87) Internationale Veröffentlichungsnummer: WO0073035

(56) Entgegenhaltungen:
- EP-A- 0 618 505
- EP-A- 0 807 856
- DE-A- 4 205 944
- DE-C- 19 648 844
- US-A- 5 337 151

## Beschreibung

Die Erfindung betrifft die Übertragung von Mikrostrukturen von einem Werkzeug auf ein zu strukturierendes Substrat mit gegeneinander verstellbaren Trägern für das Werkzeug und das Substrat in einer Richtung, aus der eine Abstandsänderung des Werkzeuges und des Substrates zueinander resultiert.

Eine derartige Einrichtung ist z. B. aus der DE 196 48 844 C1 bekannt.

Zur Übertragung von Mikrostrukturen ist es bekannt, ein Abformwerkzeug in ein formbares Material, wie z. B. eine thermoplastische Schicht, vorzugsweise unter Vakuum und bei einer Temperatur oberhalb der Erweichungstemperatur des formbaren Materials einzudrücken und dadurch dreidimensionale Strukturen mit Strukturhöhen im Bereich weniger Nanometer bis hin zu einigen hundert Mikrometern zu erzeugen.

Eine dafür geeignete Einrichtung nach der DE 196 48 844 C1 ist in der Lage, Dickenschwankungen von Abformwerkzeugen und von verwendeten formbaren Materialien unter Gewährleistung einer hohen Maßhaltigkeit auszugleichen und unterschiedliche Abformtiefen zu gewährleisten.

Die Einrichtung enthält eine Kammer mit einem gestellfesten und einem verstellbaren Kammerteil, in der die Einstellung der Druck- und Temperaturverhältnisse mit vorgegebenen Werten einer auf das feststehende Kammerteil wirkenden Kraft verbunden ist.

Es ist von Nachteil bei dieser bekannten Einrichtung, daß der Ort, an den die Strukturen in das formbare Material übertragen werden sollen, nicht bestimmbar ist.

Deshalb ist es die Aufgabe der Erfindung, eine gegenseitige kontrollierbare Ausrichtbarkeit von Werkzeug und formbarem Material zu gewährleisten.

Gemäß der Erfindung wird die Aufgabe durch eine Einrichtung zur Übertragung von Mikrostrukturen von einem Werkzeug auf ein zu strukturierendes Substrat mit gegeneinander verstellbaren Trägern für das Werkzeug und das Substrat in einer Richtung, aus der eine Abstandsänderung des Werkzeuges und des Substrates zueinander resultiert dadurch gelöst, daß zur Vermessung ausgewählter Orte in mindestens einer Meßebene, zu der die Richtung der Verstellung der Träger senkrecht gerichtet ist, ein zwischen die Träger einschiebbares Meßsystem vorgesehen ist, das in einer Meßposition mit dem Werkzeug in fester räumlicher Beziehung steht, und daß das Substrat zur Ausrichtung gegenüber dem Werkzeug parallel zur Meßebene verschiebbar ist.

Der Träger für das Werkzeug ist in einem ersten Kammerteil und der Träger für das Substrat in einem zweiten Kammerteil einer verschließbaren Kammer enthalten, in der die Übertragung der Mikrostrukturen durch Abformung erfolgt.

Vorteilhafterweise ist die Kammer als Vakuumkammer ausgebildet oder mit Schutzgas füllbar.

Das Meßsystem enthält verschiedene optische Zweige mit unterschiedlich großen Bildfeldern, wobei die Vergrößerung eines ersten optischen Zweiges ein komfortables Suchen der auszuwählenden Orte und die eines zweiten optischen Zweiges das genaue Vermessen der ausgewählten Orte in den Meßebenen ermöglicht.

Zum Einschieben des Meßsystems ist eine Transportvorrichtung vorgesehen, die unterschiedliche Antriebe für nacheinander anzufahrende Positionen enthält, wobei ein erster Antrieb den Transport von einer ersten Position außerhalb der Kammer in eine zweite Position in der geöffneten Kammer übernimmt und ein zweiter Antrieb das Meßsystem in eine, zum Werkzeug ausgerichtete Position versetzt. Die Vermessung kann dadurch ohne eine Behinderung der Abformung erfolgen.

Die ermittelten Daten werden zur Ansteuerung einer Vorrichtung zur Verschiebung des Substrates gegenüber dem Werkzeug verwendet, die in dem zweiten Kammerteil enthalten ist. Die Vorrichtung enthält zwei aufeinanderliegende, parallel zur Ebene der Substratverstellung gegeneinander bewegliche Gleitplatten, von denen eine obere Gleitplatte als kammerverschließendes Element dient.

Vorteilhafterweise ist die obere Gleitplatte mit der unteren Gleitplatte verklemmbar.

Die obere Gleitplatte kann außerdem einen ersten Teil einer Heiz- und Kühleinheit tragen, auf dem eine Halterung für das Substrat befestigt ist.

Die Kammer kann zur Veränderung der Kammerhöhe nach außen abdichtende Seitenwandteile aufweisen, die in Richtung der Verstellbarkeit der Kammerteile selbst gegeneinander verstellbar sind.

Es ist von Vorteil, wenn das Werkzeug auf seiner Umfangsfläche von einem zylindrischen Werkzeughalter umfaßt ist, der in dem ersten Kammerteil an einem plattenförmigen Körper befestigt ist.

Der plattenförmige Körper kann mit einem zweiten Teil einer Heiz- und Kühleinheit in Verbindung stehen.

Zum Entfernen des umgeformten Materials vom Werkzeug kann der Werkzeughalter an der Mantelfläche von einem Entformwerkzeug umschlossen sein, das zum Entfernen des Substrates von dem Werkzeug nach der Übertragung der Mikrostrukturen in Richtung der gegenseitigen Verstellbarkeit der Träger gegenüber dem Werkzeughalter verschiebbar ist.

Das Meßsystem, die Verschiebevorrichtung und das erste Kammerteil können zur Gewährleistung einer hohen zeitlichen Stabilität der einzelnen Systeme der Einrichtung Kanäle für eine temperierbare Flüssigkeit enthalten.

Zur Herstellung der festen räumlichen Beziehung zwischen dem Meßsystem und dem Werkzeug sind an dem Meßsystem in dessen oberen Bereich Haken befestigt zum Einhängen an passend gestaltete Haken des ersten Kammerteiles.

Weiterhin ist es von Vorteil, wenn das Substrat aus einer Trägerschicht und einem darauf aufgebrachten umformbaren Material besteht.

Auf der Trägerschicht kann auch ein Werkzeug zur Übertragung von Strukturen in das umformbare Material aufgebracht sein.

Gegenstand der Erfindung ist außerdem ein Verfahren zur Übertragung von Mikrostrukturen von einem Werkzeug auf ein zu strukturierendes Substrat mit gegeneinander verstellbaren Trägern für das Werkzeug und das Substrat in einer Richtung, aus der eine Abstandsänderung des Werkzeuges und des Substrates zueinander resultiert. Eine zur ortsgenauen Übertragung der Mikrostrukturen erforderliche Positionierung des zu strukturierenden Substrates gegenüber dem Werkzeug in einer Ebene, zu der die Richtung der Verstellung der Träger senkrecht gerichtet ist, wird dadurch ermittelt, daß aus gemessenen Strukturlagen von übertragenen Mikrostrukturen auf einem ersten strukturierten Substrat Korrekturwerte für die durch den Abstand der Mikrostruktur zu einer Marke auf dem Substrat bestimmte Positionierung bei mindestens einem weiteren zu strukturierenden Substrat gebildet werden.

Zur weiteren Erhöhung der Positioniergenauigkeit können an dem ersten Substrat zusätzlich die Lagen der Marken vor und nach der Übertragung der Mikrostrukturen zur Bildung von Korrekturwerten für die Positionierung ermittelt werden.

Soll die Positioniergenauigkeit noch weiter verbessert werden, können vor dem Auflegen eines Substrates auf den Substrathalter die Lagen von Marken auf dem Substrathalter als Korrekturwerte bestimmt werden.

Schließlich ist es auch von Vorteil, wenn nach dem Abformen eines jeden Substrates ermittelte Lagen der abgeformten Mikrostrukturen und der Marken als Korrekturwerte für die Positionierung des jeweils nachfolgend zu strukturierenden Substrates verwendet werden.

Mit der vorliegenden Erfindung wird die bei den bekannten technischen Lösungen durch die Konstruktion vorgegebene unveränderbare räumliche Anordnung des Werkzeuges zu dem formbaren Material aufgehoben und deren gegenseitige Ausrichtung mit hoher Präzision durch Ermittlung und die Manipulation der Lagebeziehungen gewährleistet.

Die Erfindung soll nachstehend anhand der schematischen Zeichnung näher erläutert werden. Es zeigen:
- Fig. 1: eine Prinzipdarstellung einer Anlage zur Abformung von Mikrostrukturen
- Fig. 2: eine perspektivische Darstellung eines Meßsystems zur Lagebestimmung ausgewählter Mikrostrukturen in einer Ebene
- Fig. 3: eine Vorrichtung zum Transport des Meßsystems in den Bereich der Abformung und aus diesem heraus
- Fig. 4: eine Vorrichtung zur Verschiebung eines abzuformenden Substrates relativ zum Werkzeug als integrierter Bestandteil des unteren Kammerteils der Abformanlage
- Fig. 5: eine Draufsicht auf die Einrichtung gemäß Fig. 4
- Fig. 6: einen Substrathalter mit aufliegendem Substrat
- Fig. 7: das obere Kammerteil der Abformanlage

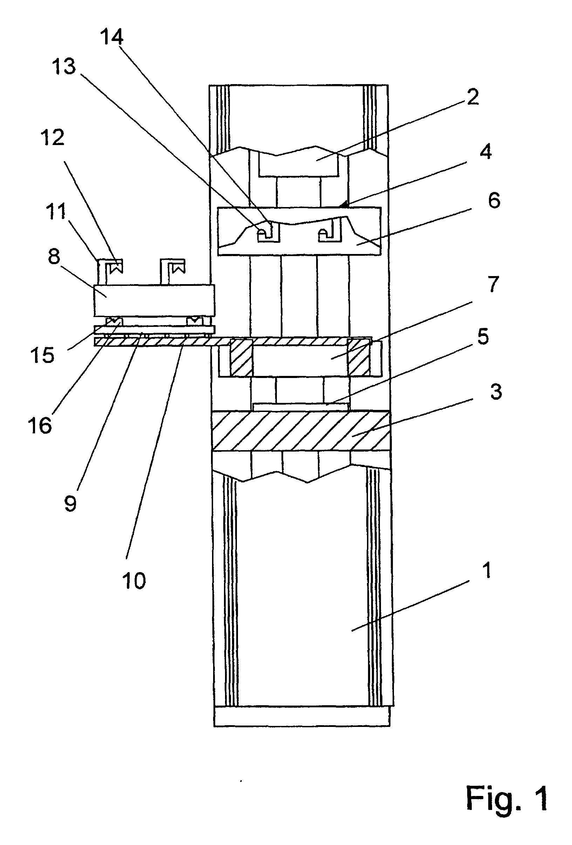

Bei der in Fig. 1 dargestellten Abformanlage werden von einem Lastrahmen 1 ein gestellfestes Teil 2 und ein verstellbares Teil 3 getragen, an denen ein oberer Flansch 4 und ein unterer Flansch 5 befestigt sind. Die Flansche 4, 5 dienen der Halterung von sich gegenüberliegenden Kammerteilen 6, 7 einer verschließbaren Kammer, die im vorliegenden Ausführungsbeispiel als Vakuumkammer ausgebildet ist. Anstatt der Vakuumkammer ist aber auch z. B. eine mit Schutzgas füllbare Kammer zu Abformzwecken geeignet.

Mit einem in den Rahmen 1 integrierten Antrieb kann der verstellbare Teil 3 unter Mitwirkung nicht dargestellter Einrichtungen, wie einer solchen zur Kraftmessung, einer Auswerte- und Ansteuereinheit und einer Einrichtung zur Wegmessung gegen den gestellfesten Teil 2 verschoben werden, wodurch ein Schließen und ein Öffnen der Kammer ermöglicht wird. Die Auswerte- und Ansteuereinheit steuert unter anderem die Positionierung des gestellfesten Teiles 2 zu dem verstellbaren Teil 3 und dient mit der Einrichtung zu Kraftmessung dazu, eine definierte Kraft zwischen dem gestellfesten Teil 2 und dem verstellbaren Teil 3 aufrecht zu erhalten.

Für den Fachmann ist sofort erkennbar, daß das gestellfeste Teil 2 und das verstellbare Teil 3 in ihrer Anordnung miteinander vertauscht sein können.

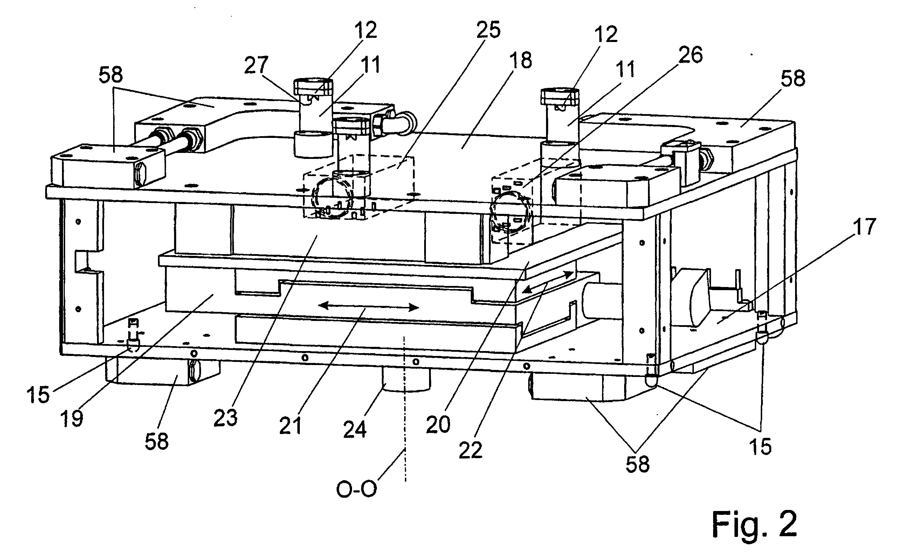

Ein in Fig. 2 noch näher zu beschreibendes Meßsystem 8 ist in abnehmbarer Weise auf ein fahrbares Gestell 9 aufgesetzt, dessen Unterlage 10 an dem unteren Kammerteil 7 befestigt ist. Die Verfahrbarkeit des Meßsystems 8 dient dazu, dieses in den Bereich der Abformung zwischen die beiden Kammerteile 6, 7 bei geöffneter Kammer hinein und wieder heraus zu bewegen. Im oberen Bereich des Meßsystems 8 vorgesehene Haken 11 weisen an ihren Enden Auflageflächen 12 auf, die als Dreipunktauflage passend gestaltet sind zu halbkugelförmigen Auflageflächen 13 an Haken 14, die am oberen Flansch 4 angebracht sind. Im eingehängten Zustand ist eine definierte Lagebeziehung zwischen dem Meßsystem 8 und dem oberen Flansch 4 hergestellt. Der untere Bereich des Meßsystems 8 besitzt halbkugelförmige Ausrichtelemente 15, die während des Einund Ausfahrvorganges auf Positionierelementen 16 in einer Dreipunktformation aufliegen und das Meßsystem 8 auf dem Gestell 9 und damit auch zur Unterlage 10 ausrichten.

Das Meßsystem 8 selbst besteht aus einem Gehäuse mit einer Bodenplatte 17 und einer Deckenplatte 18. Dieses Gehäuse kann durch eine nicht dargestellte Verkleidung an einer oder mehreren Seiten gegen äußere Einflüsse abgeschirmt sein.

Auf der Bodenplatte 17 ist ein elektrisch betriebener Kreuztisch 19 montiert, der eine Tischplatte 20 parallel zu der Bodenplatte 17 in zwei zueinander senkrechten Bewegungsrichtungen 21, 22 verstellen kann.

Die Tischplatte 20 dient als Träger für ein Meßmikroskop 23, dessen Objektiv 24 eine senkrecht zur Bodenplatte 17 gerichtete optische Achse O-O aufweist. Eine in Fig. 2 nicht erkennbare Öffnung in der Bodenplatte 17 gewährleistet den für die Meßzwecke notwendigen Strahlendurchgang. Eine für diesen Zweck vorgesehene Öffnung besitzt auch der Kreuztisch 19 in seinem mittleren Bereich. Die Größe der Öffnungen sichert eine ungehinderte Bewegung des Objektivs 24 über den gesamten Bewegungsbereich in den Bewegungsrichtungen 21, 22.

Eine definierte Positionierung des Kreuztisches 19 erfolgt mit Hilfe der Gerätesoftware.

Eine flache Bauhöhe des Meßmikroskops 23 wird durch einen bildseitig zum Objektiv 24 in horizontaler Richtung verlaufenden Strahlengang erreicht. Nach dem Umlenken der optischen Achse O-O in eine zur Tischplatte parallele Richtung wird der Strahlengang in zwei getrennte optische Zweige geteilt, von denen jeder eine CCD-Kamera 25 bzw. 26 enthält, deren Lage in gestrichelter Weise angedeutet ist. In den optischen Zweigen wird mit voneinander verschiedenen Vergrößerungen gearbeitet, so daß innerhalb des Bildfeldes der ersten CCD-Kamera 25 ein komfortables Suchen von Mikrostrukturen eines betrachteten Objektes möglich ist. Die Vergrößerung des zweiten Zweiges ist so ausgeführt, daß innerhalb des Bildfeldes der zweiten CCD-Kamera 26 das genaue Messen der Lagebeziehungen der Strukturen auf dem Objekt möglich ist.

Das Meßmikroskop 23 arbeitet mit einem Beleuchtungssystem für eine Hellfeld-Auflicht-Beleuchtung. Das Licht wird mittels eines nicht dargestellten ersten Lichtleitkabels von einer geeigneten ersten Lichtquelle bereitgestellt. Zusätzlich kann am Objektiv 24 ein nicht dargestelltes Ringlicht angebracht werden, das mittels eines zweiten, nicht dargestellten Lichtleitkabels von einer zweiten geeigneten Lichtquelle gespeist wird. Damit ist auch die Benutzung einer Dunkelfeld-Auflicht-Beleuchtung möglich.

Aus Fig. 2 ist deutlicher erkennbar, daß die an den Haken 11 vorgesehenen Auflageflächen 12 um etwa 120° zueinander versetzt ausgerichtete Kerben 27 besitzen. Von den an gegenüberliegenden Seiten der Bodenplatte 17 angebrachten halbkugelförmigen Ausrichtelementen 15 sind an einer Seite eine und an der gegenüberliegenden Seite zwei Elemente befestigt.

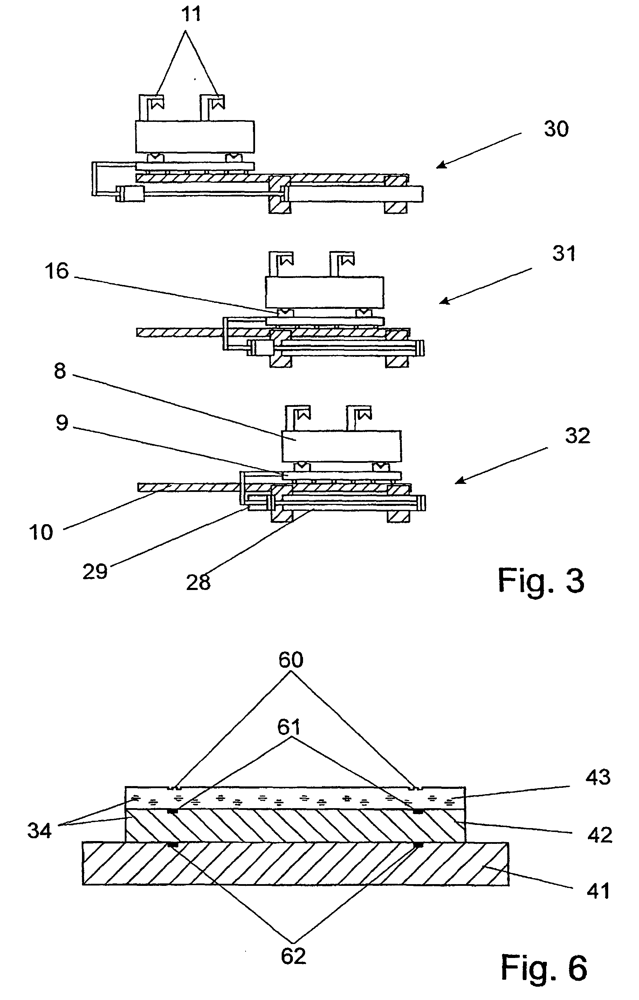

Eine in Fig. 3 schematisch dargestellte Transportvorrichtung besteht aus der an dem unteren Kammerteil 7 befestigten Unterlage 10 zur Aufnahme des fahrbaren Gestells 9 und pneumatischen Antrieben 28, 29. Der erste Antrieb 28 dient dazu, das fahrbare Gestell 9 auf der Unterlage 10 von einer außerhalb des Bereiches der Abformung liegenden Parkposition 30 in eine Zwischenposition 31, die bereits innerhalb dieses Bereiches liegt, zu verschieben.

Der zweite Antrieb 29 übernimmt den Transport von der Zwischenposition 31 in eine Einhängeposition 32, in der das Meßsystem mit seinen Haken 11 an die Haken 14 des oberen Flansches 4 angehängt werden kann.

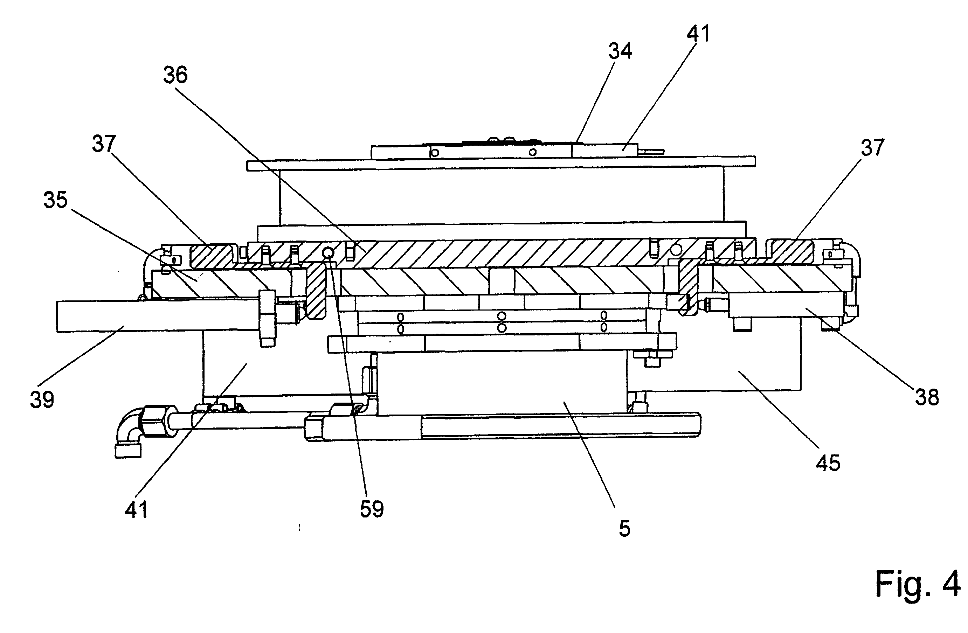

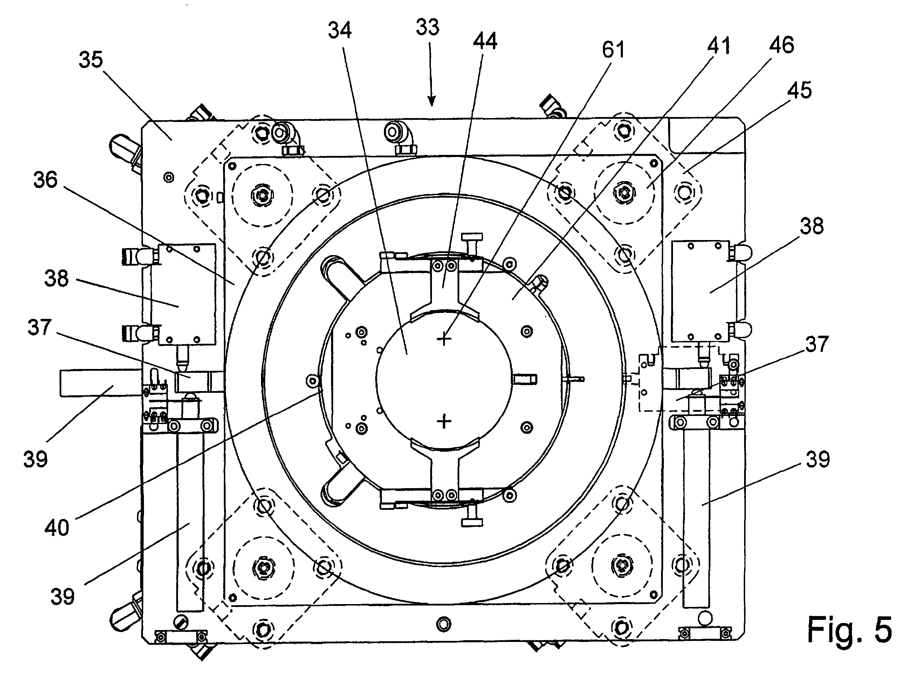

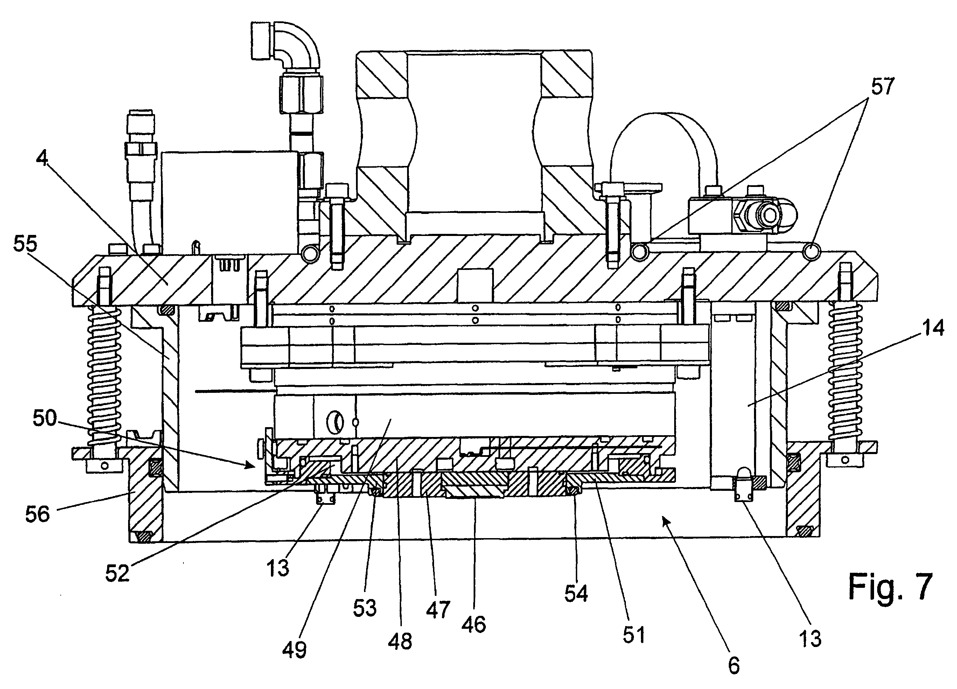

Die Abformanlage enthält in dem unteren Kammerteil 7 als weitere Teileinrichtung eine Verschiebevorrichtung 33 gemäß den Figuren 4 und 5, mit der ein zu formendes Substrat 34 in einer Ebene senkrecht zur Verschließrichtung der Kammer gegenüber einem, in der Figur 7 mit 46 bezeichneten Werkzeug verstellt werden kann.

Von zwei aufeinanderliegenden, parallel zur Ebene der Substratverstellung gegeneinander beweglichen Gleitplatten 35, 36 sind für die obere Gleitplatte 36 Anschläge 37 vorgesehen, die durch Pneumatikzylinder 38 jeweils an einer als Positionsgeber dienenden Antriebseinheit 39 auf der Gleitplatte 35 angelegt sind. Geeignete, nicht dargestellte Meßmittel kontrollieren die mit den Antriebseinheiten 39 eingestellten Positionen. Die obere Gleitplatte 36 trägt einen für die Abformung notwendigen unteren Teil 40 einer Heiz- und Kühleinheit, auf den ein Substrathalter 41 montiert ist. Auf dem Substrathalter 41 kann das Substrat 34, das wie aus Fig. 6 ersichtlich, aus einer Trägerschicht 42 und einem umformbaren Material 43 besteht, mit Hilfe von Federelementen 44 fixiert werden. Seitliche, nicht dargestellte Anschläge können zusätzlich vorgesehen sein. Üblicherweise besteht die Trägerschicht 42 aus einem strukturierten Material, wie z. B. einer fotolithografisch strukturierten Keramikplatte oder einer strukturierten Leiterplatte.

Soll das Material 43 beidseitig umgeformt werden, ist es möglich, die Trägerschicht 42 durch ein weiteres Werkzeug zu ersetzen.

Die obere Gleitplatte 36 besitzt die zusätzliche Aufgabe, den unteren Abschluß der Kammer zu bilden. Wird in der Kammer unter Vakuumbedingungen gearbeitet, wirken auf die obere Gleitplatte 36 durch den Atmosphärendruck Kräfte, zu denen keine Gegenkräfte existieren. Zum Ausschluß einer unerwünschten Verformung der Kammer und zur Gewährleistung einer definierten relativen Lage der beiden Gleitplatten 35, 36 zueinander ist die obere Gleitplatte 36 mit der unteren Gleitplatte 35 pneumatisch verklemmbar. Die dafür notwendige Kraft wird durch vier an der unteren Gleitplatte 35 befestigte Pneumatikzylinder 45 erzeugt.

Die an den Schubstangen der Pneumatikzylinder 45 zur Verfügung stehende Kraft wird durch vier Klemmplatten 46 auf die obere Gleitplatte 36 übertragen.

Das obere Kammerteil 6 enthält gemäß Fig. 7 das für die Abformung notwendige Werkzeug 46, das auf seiner Umfangsfläche von einem, an einer Grundplatte 48 abgedichtet befestigten zylindrischen Werkzeughalter 47 umfaßt ist. Die Grundplatte 48 steht mit dem oberen Teil 49 einer Heiz- und Kühleinheit in Verbindung, die an dem oberen Flansch 4 befestigt ist. Im vorliegenden Ausführungsbeispiel ist in dem oberen Kammerteil 6 zusätzlich eine Entformvorrichtung 50 enthalten, von der ein parallel zur Richtung der Verstellung der Kammerteile 6, 7 verschiebbares ringförmiges Entformwerkzeug 51 den Werkzeughalter 47 umschließt. Das Entformwerkzeug 51 bildet mit einer in die Grundplatte 48 eingearbeiteten ringförmigen Nut 52 und der Mantelfläche des Werkzeughalters 47 eine Druckkammer, in die ein Zufuhrkanal für Druckluft durch die Grundplatte 48 geführt ist. Das Entformwerkzeug 51, das stirnseitig einen Vorsprung 53 mit einer umlaufenden Dichtung 54 aufweist, liegt abgedichtet an der Mantelfläche des Werkzeughalters 47 bzw. an der äußeren Zylinderfläche der Nut 52 an. Dadurch ist gewährleistet, daß das Entformwerkzeug 51 wie der Kolben eines Pneumatikzylinders arbeiten kann. Der Bewegungsbereich wird in der einen Richtung durch die Grundplatte 48 und in der anderen Richtung durch nicht dargestellte Anschläge begrenzt. Nicht dargestellte Rückstellfedern dienen dazu, das Entformwerkzeug 51 wieder in seine Ruhestellung zu bringen, nachdem die Druckluftzufuhr beendet wurde.

Die Entformvorrichtung 50 dient dazu, das Substrat 34 nach dem Abformprozeß vom Werkzeug 46 zu trennen, indem das Substrat 34 mit dem Entformwerkzeug 51 gegen den Substrathalter 41 gedrückt wird, währenddessen die Kammer geöffnet wird. Zusätzlich kann in den sich zwischen dem Substrat 34 und dem Werkzeug 46 bildenden Raum Druckluft zur Unterstützung der Ablösung eingebracht werden. Der sich bildende Raum ist zu diesem Zweck nach außen abgedichtet.

Die Haken 14 mit den halbkugelförmigen Auflageflächen 13 sind jeweils um 120° versetzt am oberen Flansch 4 befestigt, so daß nur einer vollständig sichtbar ist. Eine nach außen abdichtende Seitenwand der. Kammer ist in Wandteile 55, 56 unterteilt, von denen das Wandteil 55 an dem Flansch 4 angebracht ist und das Wandteil 56 zum Schließen der Kammer auf einen abdichtenden äußeren Bereich des unteren Kammerteiles 7 aufsetzt. Beide Wandteile 55, 56 sind in Richtung der Verstellbarkeit der Kammerteile 6, 7 selbst gegeneinander verstellbar, wodurch die Kammerhöhe veränderbar ist.

Bei der Abformung der Strukturen des Werkzeuges 46 in das umformbare Material 43 werden Heiz- und Kühlleistungen in die Kammer eingebracht. Um die für das justierte Abformen notwendigen Genauigkeiten zu erreichen, sind im vorliegenden Ausführungsbeispiel wichtige Teile des Meßsystems 8, der Verschiebevorrichtung 33 und des oberen Kammerteils 6 mit Kanälen für eine temperierbare Flüssigkeit, vorzugsweise Wasser versehen.

So sind der Flansch 4 des oberen Kammerteiles 6 von Kühlkanälen 57 durchzogen. Auch die Haken 14 sind als Kühlblöcke ausgeführt und enthalten entsprechende Kanäle.

An der Bodenplatte 17 und an der Deckenplatte 18 des Meßsystems 8 sind Temperierblöcke 58 angebracht. Die Gleitplatten 35, 36 weisen geeignete Bohrungen 59 zur Temperierung auf.

Neben der bereits genannten Funktion obliegen der Auswerte- und Ansteuereinheit eine Vielzahl weiterer Aufgaben, wie die Steuerung des Kreuztisches 19 und des Meßsystems 8, die Kontrolle der Positionen der zwei Bewegungsrichtungen 21, 22 des Kreuztisches 19, die Auswertung der Informationen von der ersten und zweiten CCD-Kamera 25, 26 mit geeigneten Algorithmen der Bildverarbeitung und die Steuerung sämtlicher pneumatischer Einheiten sowie die der Antriebseinheiten 39 und deren Positionskontrolle. Die Auswertung der Informationen von der ersten und zweiten CCD-Kamera 25, 26 kann z. B. in der Weise erfolgen, daß die Abarbeitung des Positionier- und Abformvorganges vollautomatisch ausgeführt werden kann. Die Auswerte- und Ansteuereinheit kann des weiteren so ausgeführt sein, daß das automatische Finden von Strukturen innerhalb der Bilder der CCD-Kameras 25, 26 möglich ist.

Zur Übertragung der auf dem Werkzeug 46 vorhandenen Strukturen auf das umformbare Material 43 mit genau vorherbestimmbarer Ortslage dient die folgende Arbeitsweise.

Nachdem das Substrat 34 eingelegt und mit Hilfe der Federelemente 44 auf dem Substrathalter 41 fixiert ist, wird die Kammer durch Gegeneinanderverstellung der Kammerteile 6 und 7 geschlossen und anschließend evakuiert.

Dabei wird der verstellbare Teil 3 solange bewegt, bis sich das Werkzeug 46 und das umformbare Material 43 berühren. Die Kammerhöhe paßt sich dabei durch die Verstellbarkeit der Wandteile 55, 56 gegeneinander der Dicke des umformbaren Materials 43 an. Anschließend setzt eine Beheizung des Werkzeuges 46 und des umformbaren Materials 43 mit Hilfe der beiden Teile 40 und 49 der Heiz- und Kühleinheit ein. Durch die Krafteinwirkung infolge einer weiteren Verstellung des Teiles 3 und im Zusammenwirken mit der Auswerte- und Ansteuereinheit sowie der Einrichtung zur Kraftmessung wird eine definierte Andruckkraft zwischen dem Substrat 34 und dem Werkzeug 46 erzeugt, so daß es zu der beabsichtigten Strukturübertragung kommt. Ist die Übertragung abgeschlossen, folgt eine Abkühlphase und eine anschließende Belüftung der Kammer. Mit Hilfe der Entformvorrichtung 50 wird das umformbare Material 43 vom Werkzeug 46 getrennt.

Zur Überprüfung des Ergebnisses der Abformung werden die beiden Kammerteile 6, 7 auf einen solchen Abstand gebracht, bei dem sowohl das Meßsystem 8 mit Hilfe der Transportvorrichtung von der Parkposition 30 in die zur Messung geeignete Einhängeposition 32 gebracht als auch das Einlegen und das Entnehmen des Substrates 34 durchgeführt werden kann.

Das sich in der Parkposition 30 zusammen mit dem fahrbaren Gestell 9 befindliche Meßsystem 8 wird durch Aktivieren des ersten pneumatischen Antriebs 28 zwischen die beiden Kammerteile 6, 7 in die Zwischenposition 31 bewegt. Anschließend wird das untere Kammerteil 6 gegen das obere Kammerteil 7 verstellt, wodurch die Transportvorrichtung und das Meßsystem 8 mitbewegt werden. Die an dem Meßsystem 8 befestigten drei Haken 11 tauchen in das obere Kammerteil 7 ein bis sich die gekerbten Auflageflächen 12 oberhalb der an den drei Haken 14 befestigten Auflageflächen 13 befinden. Die Zwischenposition 31 ist so gewählt, daß die Haken 11 und 14 nicht miteinander kollidieren.

Mit Hilfe des zweiten pneumatischen Antriebs 29 wird das fahrbare Gestell 9 zusammen mit dem Meßsystem 8 in die Einhängeposition 32 gebracht, bei der sich die Auflageflächen 12, 13 in vertikaler Richtung direkt übereinander befinden. Durch ein Absenken des unteren Kammerteiles 6 wird der Vorgang des Einhängens abgeschlossen.

Das zum Werkzeug 46 in allen sechs Freiheitsgeraden definiert ausgerichtete und von dem fahrbaren Gestell 9 entkoppelte Meßsystem 8 nimmt nunmehr eine Meßposition ein.

Soll das Meßsystem 8 nach der Durchführung von Messungen wieder aus dem Bereich zwischen den beiden Kammerteilen 6, 7 herausgefahren werden, ist das fahrbare Gestell 9 zunächst wieder in die Einhängeposition 32 zu bringen. Das untere Kammerteil 6 wird zusammen mit dem fahrbaren Gestell 9 gegen das obere Kammerteil 7 verstellt, bis es zur Auflage der Ausrichtelemente 15 auf den Positionierelementen 16 kommt. Die Kopplung der Auflageflächen 12, 13 wird aufgehoben, wonach beide in vertikaler Richtung übereinanderliegen. Während der zweite pneumatische Antrieb 29 den Transport in die Zwischenposition 31 übernimmt, bringt der erste pneumatische Antrieb 28 das fahrbare Gestell 9 mit dem Meßsystem 8 in die Parkposition 30. Beim Ausfahren in die Parkposition 30 müssen sich die zu transportierenden Elemente in einem genügend großen Freiraum befinden.

Da eine direkte Ermittlung der Lagebeziehungen zwischen dem Werkzeug 46 und dem Substrat 34 während des Abformvorganges nicht möglich ist, macht es sich erforderlich, in einer der eigentlichen Abformung vorangestellten Probeabformung die Ortskoordinaten von abgeformten Mikrostrukturen 60 auf dem umformbaren Material und/oder von bereits vorhandenen Marken 61 auf der Trägerschicht 42 vor und nach dem Abformen zu ermitteln. Das jeweilige Substrat 34 kann dann anhand der ermittelten Ortskoordinaten in die erforderliche Position gegenüber dem Werkzeug 46 gebracht werden, so daß ein positioniertes Abformen erreicht werden kann. Auf dem Werkzeug 46 vorhandene Strukturen können auf das umformbare Material 43 mit genau vorherbestimmbarer Ortslage übertragen werden.

Zur Durchführung von Messungen an den Mikrostrukturen 60, den Marken 61 oder an vorhandenen Marken 62 auf dem Substrathalter 41 wird das Meßmikroskop 24 zunächst in die Meßposition gebracht und anschließend mit Hilfe des Kreuztisches 19 über der Trägerschicht 42 in den Bewegungsrichtungen 21, 22 verfahren, bis die zu vermessenden Mikrostrukturen 60, die Marken 61 oder die Marke 62 erfaßt wird. Eine Scharfeinstellung erfolgt durch Anheben und Absenken des unteren Kammerteiles 6. Die Daten der durch die mikroskopische Abbildung von den CCD-Kameras 25, 26 aufgenommenen Bilder werden der Auswerte- und

Ansteuereinheit zur weiteren Verarbeitung, insbesondere für die zur ortsgenauen Abformung erforderliche Positionierung des Substrates 34 mit Hilfe der Verschiebevorrichtung 33 zur Verfügung gestellt.

Für den Vorgang der Positionierung wird die durch die vier Pneumatikzylinder 45 und die Klemmplatten 46 hervorgerufene Klemmung zwischen der oberen und der unteren Gleitplatte 35, 36 aufgehoben. Es ist vorteilhaft, wenn die Lagebeziehungen zwischen den Marken 61 auf der Trägerschicht 42 und den in das abformbare Material 43 kopierten Mikrostrukturen 60 des Werkzeuges 46 vorgegeben sind. Die Auswerte- und Ansteuereinheit ist dann in der Lage, die einzustellenden Positionen des auf dem Substrathalter 41 befestigten Substrates 34 unter Zuhilfenahme der in der Probeabformung für die Mikrostrukturen 60 sowie für die Marken 61 und bei Bedarf für die Marken 62 ermittelten Ortskoordinaten zu berechnen und die Ansteuerung der Antriebseinheiten 39 vorzunehmen. Die Antriebseinheiten 39 definieren durch ihre Einstellung die Position, in die die Anschläge 37 für die obere Gleitplatte 36 durch die Kraft der Pneumatikzylinder 38 zu bringen sind, wodurch der Substrathalter -41 mit dem Substrat 34 gegenüber dem Werkzeug 46 in einer zur Oberfläche der Gleitplatten 35, 36 parallelen Ebene in den translatorischen Koordinaten und in der Winkellage positioniert wird. Nach der Deaktivierung der Pneumatikzylinder 38 bleibt die Position der oberen Gleitplatte 36 durch das Eigengewicht zunächst erhalten, bevor die wieder hergestellte Klemmung zwischen der oberen und der unteren Gleitplatte 35, 36 die Position der oberen Gleitplatte 36 stabilisiert.

Die eingestellte Position kann dadurch überprüft werden, daß die Koordinaten der Marke 61 auf der Trägerschicht 42 erneut in der bereits beschriebenen Weise bestimmt werden. Gegebenenfalls macht sich eine nochmalige Positionseinstellung mit der Verschiebevorrichtung 33 erforderlich.

Mit der erfindungsgemäßen Lösung können auf einem Träger enthaltene Strukturen oder Objekte mit sehr hoher Genauigkeit zu vorherbestimmbaren Orten in einem plastisch verformbaren Material übertragen werden. Das wird erreicht durch Messungen der Ortskoordinaten der übertragenen Strukturen oder Objekte beziehungsweise von vorhandenen Strukturen im Bereich des Übertragungsgebietes und anschließender Positionierung des zu strukturierenden Bereiches gegenüber dem Träger in Abhängigkeit von den gemessenen Ortskoordinaten.

Die Messungen im Bereich des Übertragungsgebietes müssen an solchen Orten erfolgen, daß die Erfassung aller sich auf die Ortskoordinaten der übertragenen Strukturen oder Objekte auswirkenden Verschiebungen in einer Richtung senkrecht zur Richtung der Übertragung der Strukturen oder Objekte gewährleistet ist.

Im vorliegenden Ausführungsbeispiel sind zu diesem Zweck die folgenden Arbeitsweisen für den Ablauf des positionierten Abformens vorgesehen:

In der einfachsten Form, dem Grundprinzip, wird zunächst ein erstes Substrat 34 abgeformt (Grobabformung) und danach die Lage der abgeformten Mikrostrukturen 60 im umformbaren Material 43 vermessen. Weitere zu bearbeitende Substrate 34 werden nach dem Vermessen der Marken 61 auf der Trägerschicht mit Hilfe der Verschiebevorrichtung in die Position gebracht, in der bei einer anschließenden Abformung die Strukturen des Werkzeuges 46 in einer definierten Abstandsrelation zu den Marken 61 in das umformbare Material 43 kopiert werden. Die Koordinaten der in das umformbare Material 43 kopierten Strukturen 60 des Werkzeuges 46 sind aus der Probeabformung bekannt.

Eine erste Verfeinerung des positionierten Abformens sieht vor, die Lagen der Marken 61 auf der Trägerschicht 42 vor und nach der Probeabformung des ersten Substrates 34 sowie die Lage der abgeformten Mikrostrukturen 60 im umformbaren Material 43 zu vermessen und die Meßergebnisse zur Ausrichtung der weiteren zu bearbeitenden Substrate 34 zu verwenden. Hierbei erfolgt wiederum zunächst eine Bestimmung der Ortskoordinaten der Marken 61 als Grundlage für die erforderliche Positionierung mit der Verschiebeeinrichtung 33. Von Vorteil ist es auch, wenn die Strukturlagen in der Trägerschicht 42 und im umformbaren Material nach dem Abformen für die jeweils nachfolgende Abformung erfaßt werden. Mit dieser ersten Verfeinerung des positionierten Abformens wird erreicht, daß sich im Abformprozeß durch Heizen, Kühlen und Abformen entstehende Lageabweichungen des Substrates 34 gegenüber dem Substrathalter 41 nicht als Fehler auswirken.

Bei einer nochmaligen Verfeinerung des Abformverfahrens werden auch die Markenlagen auf dem Substrathalter 41 mit einbezogen. Die Marken 62 werden bereits vor dem Einlegen des ersten Substrates 34 vermessen. Vermessen werden dann die Markenlagen auf der Trägerschicht 42 vor und nach dem Abformen und die Lage der abgeformten Mikrostrukturen 60 in dem umformbaren Material 43.

Bei den weiteren zu bearbeitenden Substraten 34 wird vor dem Einlegen des Substrates 34 die Lage der Marken 62 auf dem Substrathalter 41 und die Markenlage der Trägerschicht des eingelegten Substrates 34 vermessen. Anschließend wird positioniert und abgeformt. Nach dem Abformen werden die Markenlagen in der Trägerschicht 42 und im umformbaren Material für die jeweils nachfolgende Abformung erfaßt. Mit der nochmaligen Verfeinerung des Abformverfahrens wird erreicht, daß sich Drifterscheinungen zwischen dem oberen Kammerteil 6 und dem bei einer Messung daran fixierten Meßsystem 8 einerseits und dem unteren Kammerteil 7 mit dem daran befestigten Positioniersystem 33 andererseits nicht als Fehler auswirken.

## Patentansprüche

1. Einrichtung zur Übertragung von Mikrostrukturen von einem Werkzeug auf ein zu strukturierendes Substrat mit gegeneinander verstellbaren Trägern für das Werkzeug und das Substrat in einer Richtung, aus der eine Abstandsänderung des Werkzeuges und des Substrates zueinander resultiert, **dadurch gekennzeichnet, daß** zur Vermessung ausgewählter Orte in mindestens einer Meßebene, zu der die Richtung der Verstellung der Träger senkrecht gerichtet ist, ein zwischen die Träger einschiebbares Meßsystem (8) vorgesehen ist, das in einer Meßposition mit dem Werkzeug (46) in fester räumlicher Beziehung steht, und daß das Substrat (34) zur Ausrichtung gegenüber dem Werkzeug (46) parallel zur Meßebene verschiebbar ist.

2. Einrichtung nach Anspruch 1, **dadurch gekennzeichnet, daß** der Träger für das Werkzeug in einem ersten Kammerteil (6) und der Träger für das Substrat (34) in einem zweiten Kammerteil (7) einer verschließbaren Kammer enthalten sind, in der die Übertragung der Mikrostrukturen durch Abformung erfolgt.

3. Einrichtung nach Anspruch 2, **dadurch gekennzeichnet, daß** die Kammer als Vakuumkammer ausgebildet ist.

4. Einrichtung nach Anspruch 2, **dadurch gekennzeichnet, daß** die Kammer mit Schutzgas füllbar ist.

5. Einrichtung nach einem der Ansprüche 1 bis 4, **dadurch gekennzeichnet, daß** das Meßsystem verschiedene optische Zweige mit unterschiedlich großen Bildfeldern enthält, wobei die Vergrößerung eines ersten optischen Zweiges ein komfortables Suchen der auszuwählenden Orte und die eines zweiten optischen Zweiges das genaue Vermessen der ausgewählten Orte in den Meßebenen ermöglicht.

6. Einrichtung nach Anspruch 5, **dadurch gekennzeichnet, daß** zum Einschieben des Meßsystems (8) eine Transportvorrichtung vorgesehen ist, die unterschiedliche Antriebe (28, 29) für nacheinander anzufahrende Positionen enthält, wobei ein erster Antrieb (28) den Transport von einer ersten Position (30) außerhalb der Kammer in eine zweite Position (31) in der geöffneten Kammer übernimmt und ein zweiter Antrieb (29) das Meßsystem (8) in eine, zum Werkzeug (46) ausgerichtete Position (32) versetzt.

7. Einrichtung nach Anspruch 6, **dadurch gekennzeichnet, daß** in dem zweiten Kammerteil (7) eine Vorrichtung zur Verschiebung (33) des Substrates (34) gegenüber dem Werkzeug (46) enthalten ist, die zwei aufeinanderliegende, parallel zur Ebene der Substratverstellung gegeneinander bewegliche Gleitplatten (35, 36) enthält, von denen eine obere Gleitplatte (36) als kammerverschließendes Element dient.

8. Einrichtung nach Anspruch 7, **dadurch gekennzeichnet, daß** die obere Gleitplatte (36) mit der unteren Gleitplatte (35) verklemmbar ist.

9. Einrichtung nach Anspruch 8, **dadurch gekennzeichnet, daß** die obere Gleitplatte (36) einen ersten Teil (40) einer Heiz- und Kühleinheit trägt, auf den eine Halterung für das Substrat (34) befestigt ist.

10. Einrichtung nach Anspruch 9, **dadurch gekennzeichnet, daß** die Kammer zur Veränderung der Kammerhöhe nach außen abdichtende Seitenwandteile aufweist, die in Richtung der Verstellbarkeit der Kammerteile (6, 7) selbst gegeneinander verstellbar sind.

11. Einrichtung nach Anspruch 10, **dadurch gekennzeichnet, daß** das Werkzeug (46) auf seiner Umfangsfläche von einem zylindrischen Werkzeughalter (47) umfaßt ist, der in dem ersten Kammerteil (6) an einem plattenförmigen Körper befestigt ist.

12. Einrichtung nach Anspruch 11, **dadurch gekennzeichnet, daß** der plattenförmige Körper mit einem zweiten Teil (49) einer Heiz- und Kühleinheit in Verbindung steht.

13. Einrichtung nach Anspruch 12, **dadurch gekennzeichnet, daß** der Werkzeughalter (47) an der Mantelfläche von einem Entformwerkzeug (51) umschlossen ist, das zum Entfernen des Substrates (34) von dem Werkzeug (46) nach der Übertragung der Mikrostrukturen in Richtung der gegenseitigen Verstellbarkeit der Träger gegenüber dem Werkzeughalter (47) verschiebbar ist.

14. Einrichtung nach Anspruch 13, **dadurch gekennzeichnet, daß** das Meßsystem (8), die Verschiebevorrichtung (33) und das erste Kammerteil (6) Kanäle für eine temperierbare Flüssigkeit enthalten.

15. Einrichtung nach Anspruch 14, **dadurch gekennzeichnet, daß** zur Herstellung der festen räumlichen Beziehung zwischen dem Meßsystem (8) und dem Werkzeug (46) an dem Meßsystem (8) in seinem oberen Bereich Haken (11) besfestigt sind zum Einhängen an passend gestaltete Haken (14) des ersten Kammerteiles (6).

16. Einrichtung nach Anspruch 14, **dadurch gekennzeichnet, daß** das Substrat (34) aus einer Trägerschicht (42) und einem darauf aufgebrachten umformbaren Material (43) besteht.

17. Einrichtung nach Anspruch 14, **dadurch gekennzeichnet, daß** auf der Trägerschicht (42) ein Werkzeug zur Übertragung von Strukturen in das umformbare Material (43) aufgebracht ist.

18. Verfahren zur Übertragung von Mikrostrukturen von einem Werkzeug auf ein zu strukturierendes Substrat mit gegeneinander verstellbaren Trägern für das Werkzeug und das Substrat in einer Richtung, aus der eine Abstandsänderung des Werkzeuges und des Substrates zueinander resultiert, **dadurch gekennzeichnet, daß** eine zur ortsgenauen Übertragung der Mikrostrukturen (60) erforderliche Positionierung des zu strukturierenden Substrates (34) gegenüber dem Werkzeug (46) in einer Ebene, zu der die Richtung der Verstellung der Träger senkrecht gerichtet ist, dadurch ermittelt wird, daß aus gemessenen Strukturlagen von übertragenen Mikrostrukturen (60) auf einem ersten strukturierten Substrat (34) Korrekturwerte für die durch den Abstand der Mikrostruktur (60) zu einer Marke (61) auf dem Substrat (34) bestimmte Positionierung bei mindestens einem weiteren zu strukturierenden Substrat (34) gebildet werden.

19. Verfahren nach Anspruch 17, **dadurch gekennzeichnet, daß** an dem ersten Substrat (34) zusätzlich die Lagen der Marken (61) vor und nach der Übertragung der Mikrostrukturen (60) zur Bildung von Korrekturwerten für die Positionierung ermittelt werden.

20. Verfahren nach Anspruch 18, **dadurch gekennzeichnet, daß** zusätzlich vor dem Auflegen eines Substrates (34) auf den Substrathalter (41) die Lagen von Marken (62) auf dem Substrathalter (41) bestimmt werden, um als Korrekturwerte zu dienen.

21. Verfahren nach Anspruch 19 oder 20, **dadurch gekennzeichnet, daß** nach dem Abformen eines jeden Substrates (34) die Lagen der abgeformten Mikrostrukturen (60) und der Marken (61) als Korrekturwerte für die Positionierung des jeweils nachfolgend zu strukturierenden Substrates (34) bestimmt werden.

## Claims

1. Device for transferring microstructures from a tool to a substrate which is to be structured including supports for the tool and the substrate which are movable towards one another in a direction which results in a change in the spacing of the tool and the substrate, **characterised in that** provided for measuring selected locations in at least one measuring plane, directed perpendicular to which is the direction of displacement of the supports, there is a measuring system (8), which may be inserted between the supports and is in a fixed spatial relationship with the tool (46) in a measuring position and that the substrate (34) is displaceable parallel to the measuring plane for alignment with respect to the tool (46).

2. Device as claimed in Claim 1, **characterised in that** the support for the tool is contained in a first chamber portion (6) and the support for the substrate (34) is contained in a second chamber portion (7) of a closable chamber in which the transfer of the microstructures is effected by forming.

3. Device as claimed in Claim 2, **characterised in that** the chamber is constructed in the form of a vacuum chamber.

4. Device as claimed in Claim 2, **characterised in that** the chamber is fillable with protective gas.

5. Device as claimed in one of Claims 1 to 4, **characterised in that** the measuring system includes different optical branches with image fields of different sizes, the magnification of a first optical branch enabling comfortable searching for the locations to be selected and that of a second optical branch enabling the precise measurement of the selected locations in the measuring plane.

6. Device as claimed in Claim 5, **characterised in that** a transport device is provided for insertion of the measuring system (8) which includes different drives (28, 29) for positions which are to be approached successively, whereby a first drive (28) is responsible for the transport from a first position (30) outside the chamber into a second position (31) in the open chamber and a second drive (29) shifts the measuring system (8) into a position (32) aligned with the tool (46).

7. Device as claimed in Claim 6, **characterised in that** contained in the second chamber portion (7) there is an apparatus for displacing (33) the substrate (34) with respect to the tool (46), which includes two sliding plates (35, 36) which rest on one another and are movable with respect to one another parallel to the plane of the substrate displacement and of which an upper sliding plate (36) serves as a chamber-closing element.

8. Device as claimed in Claim 7, **characterised in that** the upper sliding plate (36) is lockable to the lower sliding plate (35).

9. Device as claimed in Claim 8, **characterised in that** the upper sliding plate (36) carries a first portion (40) of a heating and cooling unit, secured onto which is a mounting for the substrate (34).

10. Device as claimed in Claim 9, **characterised in that** the chamber has outwardly sealing side wall portions for changing the chamber height, which are displaceable with respect to one another in the direction of the displaceability of the chamber portions (6, 7) themselves.

11. Device as claimed in Claim 10, **characterised in that** the peripheral surface of the tool (46) is surrounded by a cylindrical tool holder (47), which is secured in the first chamber portion (6) to a plate-shaped body.

12. Device as claimed in Claim 11, **characterised in that** the plate-shaped body is connected to a second portion (49) of a heating and cooling unit.

13. Device as claimed in Claim 12, **characterised in that** the surface of the tool holder (47) is surrounded by a demoulding tool (51), which is displaceable with respect to the tool holder (47) in the direction of the mutual displaceability of the supports for removing the substrate (34) from the tool (46) after the transfer of the microstructures.

14. Device as claimed in Claim 13, **characterised in that** the measuring system (8), the displacement apparatus (33) and the first chamber portion (6) include passages for a temperable liquid.

15. Device as claimed in Claim 14, **characterised in that** for the purpose of producing the fixed spatial relationship between the measuring system (8) and the tool (46), hooks (11) are fastened to the measuring system (8) in its upper region for suspending it on matching hooks (14) on the first chamber portion (6).

16. Device as claimed in Claim 14, **characterised in that** the substrate (34) comprises a support layer (42) and a deformable material (43) applied thereon.

17. Device as claimed in Claim 14, **characterised in that** a tool for transferring structures into the deformable material (43) is applied to the support layer (42).

18. Method of transferring microstructures from a tool onto a substrate which is to be structured including supports which are displaceable towards one another for the tool and the substrate in a direction from which a change in the spacing of the tool and the substrate results, **characterised in that** a positioning, which is necessary for locationally correctly transferring the microstructures (60), of the substrate (34) to be structured with respect to the tool (46) in a plane, aligned vertically to which is the direction of the displacement of the supports, is determined by forming correction values, from measured structure positions of transferred microstructures (60) on a first structured substrate (34), for the positioning determined by the spacing of the microstructure (60) to a mark (61) on the substrate (34) with at least one further substrate (34) to be structured.

19. Method as claimed in Claim 17, **characterised in that** on the first substrate (34), the positions of the marks (61) are additionally determined before and after the transfer of the microstructures (60) to form correction values for the positioning.

20. Method as claimed in Claim 18, **characterised in that** before the application of a substrate (34) to the substrate holder (41), the positions of marks (62) on the substrate holder (41) are additionally determined in order to serve as correction values.

21. Method as claimed in Claim 19 or 20, **characterised in that** after forming each substrate (34) the positions of the formed microstructures (60) and of the marks (61) are determined as correction values for the positioning of the substrate (34) which is subsequently to be structured.

## Revendications

1. Dispositif de transfert de microstructures d'un outil à un substrat à structurer comportant des supports pour l'outil et le substrat déplaçables l'un par rapport à l'autre dans un sens qui fait varier la distance entre l'outil et le substrat, **caractérisé en ce que** pour mesurer des lieux sélectionnés dans au moins un plan de mesure par rapport auquel le sens du déplacement des supports est orienté perpendiculairement, il est prévu un système de mesure (8), à introduire entre les supports, qui, dans une position de mesure, est dans une relation spatiale fixe avec l'outil (46), et **en ce que** pour l'orientation par rapport à l'outil (46), le substrat peut coulisser parallèlement au plan de mesure.

2. Dispositif selon la revendication 1, **caractérisé en ce que** le support de l'outil est contenu dans une première partie (6) et le support du substrat (34) est contenu dans une deuxième partie (7) d'une chambre qui peut être fermée et dans laquelle le transfert des microstructures se fait par moulage par déformation plastique.

3. Dispositif selon la revendication 2, **caractérisé en ce que** la chambre est réalisée en tant que chambre à vide.

4. Dispositif selon la revendication 2, **caractérisé en ce que** la chambre peut être remplie d'un gaz de protection.

5. Dispositif selon l'une des revendications 1 à 4, **caractérisé en ce que** le système de mesure contient différentes branches optiques avec des champs d'image de différentes dimensions, le grossissement d'une première branche optique permettant une recherche confortable des lieux à sélectionner et le grossissement d'une deuxième branche optique permettant de mesurer précisément les lieux sélectionnés dans les plans de mesure.

6. Dispositif selon la revendication 5, **caractérisé en ce que** pour introduire le système de mesure (8) il est prévu un dispositif de transport qui contient différents dispositifs d'entraînement (28, 29) pour des positions à approcher successivement, un premier dispositif d'entraînement (28) assurant le transport d'une première position (30) à l'extérieur de la chambre à une deuxième position (31) dans la chambre ouverte, et un deuxième dispositif d'entraînement (29) déplaçant le système de mesure (8) dans une position (32) orientée par rapport à l'outil (46).

7. Dispositif selon la revendication 6, **caractérisé en ce que** dans la deuxième partie (7) de la chambre se trouve un dispositif pour le coulissement (33) du substrat (34) par rapport à l'outil (46), qui contient deux plaques glissantes (35, 36) superposées, déplaçables l'une par rapport à l'autre parallèlement au plan du déplacement du substrat, dont une plaque glissante supérieure (36) sert d'élément fermant la chambre.

8. Dispositif selon la revendication 7, **caractérisé en ce que** la plaque glissante supérieure (36) peut être serrée avec la plaque glissante inférieure (35).

9. Dispositif selon la revendication 8, **caractérisé en ce que** la plaque glissante supérieure (36) porte une première partie (40) d'une unité de chauffage et de refroidissement sur laquelle est fixé un support pour le substrat (34).

10. Dispositif selon la revendication 9, **caractérisé en ce que** pour faire varier la hauteur de la chambre, la chambre comporte des parties de paroi latérales étanches vers l'extérieur, qui sont déplaçables les unes par rapport aux autres dans la direction de la possibilité de déplacement des parties (6, 7) de la chambre elles-mêmes.

11. Dispositif selon la revendication 10, **caractérisé en ce que** l'outil (46) est entouré, sur sa surface périphérique, par un porte-outil (47) cylindrique qui est fixé dans la première partie (6) de la chambre, sur un corps en forme de plaque.

12. Dispositif selon la revendication 11, **caractérisé en ce que** le corps en forme de plaque est en liaison avec une deuxième partie (49) d'une unité de chauffage et de refroidissement.

13. Dispositif selon la revendication 12, **caractérisé en ce que** le porte-outil (47) est enfermé, sur sa surface d'enveloppe, par un outil de démoulage (51) qui, pour enlever le substrat (34) de l'outil (46), peut coulisser par rapport au porte-outil (47), dans la direction de la possibilité de déplacement réciproque des supports, après transfert des microstructures.

14. Dispositif selon la revendication 13, **caractérisé en ce que** le système de mesure (8), le dispositif de coulissement (33) et la première partie (6) de la chambre contiennent des canaux pour un liquide qui peut être tempéré.

15. Dispositif selon la revendication 14, **caractérisé en ce que** pour réaliser la relation spatiale fixe entre le système de mesure (8) et l'outil (46), des crochets (11) sont fixés au système de mesure (8), dans sa zone supérieure, et sont destinés à s'accrocher à des crochets (14) de forme adaptée de la première partie (6) de la chambre.

16. Dispositif selon la revendication 14, **caractérisé en ce que** le substrat (34) est constitué d'une couche de support (42) et d'une matière (43) déformable appliquée sur celle-ci.

17. Dispositif selon la revendication 14, **caractérisé en ce qu'**un outil, destiné au transfert de structures dans la matière déformable (43), est placé sur la couche de support (42).

18. Procédé de transfert de microstructures d'un outil à un substrat à structurer comportant des supports pour l'outil et le substrat, déplaçables l'un par rapport à l'autre dans un sens qui fait varier la distance entre l'outil et le substrat, **caractérisé en ce qu'**un positionnement, nécessaire au transfert localement précis des microstructures (60), du substrat (34) à structurer et par rapport à l'outil (46), dans un plan par rapport auquel le sens de déplacement des supports est orienté perpendiculairement, est déterminé **en ce qu'**à partir de positions mesurées de microstructures (60) transférées sur un premier substrat (34) structuré, on forme des valeurs de correction pour le positionnement défini par la distance entre la microstructure (60) et une marque (61) sur le substrat (34), pour au moins un autre substrat (34) à structurer.

19. Procédé selon la revendication 18, **caractérisé en ce que** sur le premier substrat (34) on détermine en outre les positions des marques (61) avant et après le transfert des microstructures (60), pour former des valeurs de correction du positionnement.

20. Procédé selon la revendication 18, **caractérisé en ce qu'**avant de placer un substrat (34) sur le porte-substrat (41), on détermine en outre les positions de marques (62) sur le porte-substrat (41), pour servir de valeurs de correction.

21. Procédé selon la revendication 19 ou 20, **caractérisé en ce qu'**après copie de chaque substrat (34), les positions des microstructures (60) copiées et des marques (61) sont déterminées comme valeurs de correction pour le positionnement du substrat (34) suivant à structurer.
